# EUROPÄISCHE PATENTSCHRIFT

(11) **EP 0 997 747 B1**
(45) Veröffentlichungstag und Bekanntmachung des Hinweises auf die Patenterteilung: **13.04.2005**
(21) Anmeldenummer: 99120160.9
(22) Anmeldetag: 08.10.1999
(51) Int. Cl.: G01S 15/04, H03K 17/945, G01S 7/526, G01S 7/52

(54) **Verfahren zur Betriebsoptimierung eines Ultraschall-Näherungsschalters und Ultraschall-Näherungsschalters mit Betriebsoptimierung**
Method for optimising the operation of an ultrasonic proximity switch and ultrasonic proximity switch with optimised operation
Méthode pour optimiser l'opération d'un commutateur de proximité et commutateur de proximité à opération optimisée

(30) Priorität: 20.10.1998 DE 19848287
(43) Veröffentlichungstag der Anmeldung: 03.05.2000
(73) Patentinhaber: SIEMENS AKTIENGESELLSCHAFT, 80333 München (DE)
(72) Erfinder: Schwarz, Robert, Dipl.-Ing. (FH), 92272 Freudenberg (DE)

(56) Entgegenhaltungen:
- EP-A- 0 447 076
- EP-A- 0 484 565
- EP-A- 0 981 202
- DD-A- 281 259
- US-A- 5 277 065

## Beschreibung

Die Erfindung bezieht sich auf ein Verfahren zur Betriebsoptimierung eines Ultraschall-Näherungsschalters, der einen Ultraschall-Wandler, einen Oszillator, einen Verstärker und einen Mikroprozessor umfaßt, wobei der Oszillator den Ultraschall-Wandler mit einer Oszillatorfrequenz anregt und der Ultraschall-Wandler daraufhin ein Ultraschallsignal mit entsprechender Sendefrequenz aussendet, das er nach Reflexion als Ultraschallechosignal empfängt und in ein elektrisches Signal umwandelt, das im Ultraschall-Näherungsschalter weiterverarbeitet wird und proportional zur Amplitude des empfangenen Ultraschallechosignals ist und das durch steuernden Eingriff des Mikroprozessors auf eine Meßeinrichtung amplitudenmäßig ausgewertet wird.

Weiterhin betrifft die Erfindung einen Ultraschall-Näherungsschalter mit einem Ultraschall-Wandler, mit einem Oszillator, durch den der Ultraschall-Wandler zur Aussendung von Ultraschallwellen mit einer der Oszillatorfrequenz entsprechenden Sendefrequenz anregbar ist und mit einem Mikroprozessor zur Steuerung und Auswertung der Sende- und Empfangssignale des Ultraschall-Näherungsschalters und mit einer vom Mikroprozessor steuerbaren Meßeinrichtung, die zur Messung der Amplitude eines im Ultraschall-Näherungsschalter nach Empfang des Ultraschall-Echosignals weiterverarbeiteten elektrischen Signals dient, das proportional zur Amplitude des Ultraschall-Echosignals ist.

Ein Verfahren zur Betriebsoptimierung, z.B. zum Sendefrequenzabgleich, eines Ultraschall-Näherungsschalters der obengenannten Art ist bekannt. Dabei handelt es sich um einen fertigungsseitigen, relativ aufwendigen Sendefrequenzabgleichvorgang vor Auslieferung des Ultraschall-Näherungsschalters. Verschiedene Meß- und Einstellanschlüsse müssen kontaktiert werden, um mit Hilfe von Meßgeräten den optimalen Abgleichwert zu finden. Nach Anpassen der Schaltung durch Einlöten eines entsprechenden Bauelements muß die Funktion nochmals überprüft werden. In der Regel können Trimmer zur Frequenzeinstellung wegen Problemen beim Verguß, der Temperaturdrift, dem Preis und der Langzeitzuverlässigkeit nicht eingesetzt werden. Ein Laser oder Sandstrahlabgleich ist teuer und außerdem nicht möglich, weil ein Maximum erst erkannt wird, wenn der optimale Wert bereits überschritten ist.

Ein weiteres Verfahren zur Betriebsoptimierung eines Näherungsschalters betrifft die optimale Ausrichtung seines Ultraschall-Wandlers auf den Reflektor. Besonders in kritischen Fällen mit geringen Echo-Signalreserven ist eine geeignete Ausricht-Hilfe sinnvoll, insbesondere wenn sie z.B. auch Informationen über eventuelle Störsignale im Übertragungsweg oder Einflüsse, die durch interne Gerätefehler hervorgerufen werden, liefern kann. Bisher wurden meist recht aufwendige Zusatzschaltungen entwickelt, die z.B. die Signalamplitude des Echos durch Helligkeitsschwankungen einer Leuchtdiode darstellen bzw. durch Blinken der Leuchtdiode zu geringe Signalreserven anzeigen. Die bisherigen Lösungen weisen allerdings meist einen erheblichen Schaltungsaufwand auf. Helligkeitsschwankungen der Leuchtdiode sind bei Tageslicht nur schwer zu unterscheiden. Weiterhin ist zu bemerken, daß die unterschiedlichen Pegel nicht eindeutig quantifizierbar und vergleichbar sind.

Ein Verfahren der oben genannten Art für Ultraschall-Wandler ist aus der EP 0 447 076 A2 bekannt. Hier wird die Betriebsfrequenz eines Wandlers angepaßt an unterschiedliche Betriebsbedingungen optimal gesteuert. Die EP 0 484 565 A1 offenbart eine integrierte Selbststeuerung bei einem Ultraschall-Näherungsschalter, der einen integrierten Schaltkreis mit einem Sende-Oszillator aufweist. Zur Erzeugung eines Sendetaktes sind auf dem integrierten Schaltkreis zusätzliche Mittel vorgesehen. Über ein an den Schaltkreis angelegtes Steuersignal ist es möglich, zwischen diesem Sendetakt und einem von außen von einer Auswerteelektronik zugeführten Sendetakt zu wählen.

Der Erfindung liegt die Aufgabe zugrunde, ein Verfahren der obengenannten Art anzugeben, das mit geringen Kosten und Hardware-Aufwand eine Betriebsoptimierung, z.B. einen Sendefrequenzabgleich oder eine Ausricht-Optimierung auch bei einem vergossenen Ultraschall-Näherungsschalter ermöglicht.

Weiterhin besteht die Aufgabe, einen Ultraschall-Näherungsschalter der obengenannten Art zu schaffen, der ohne großen zusätzlichen Kostenaufwand eine Betriebsoptimierung, z.B. einen Sendefrequenzabgleich oder eine Ausricht-Optimierung ermöglicht.

Die erste Aufgabe wird dadurch gelöst, daß das zur Amplitude des empfangenen Ultraschall-Echosignals proportional weiter-verarbeitete elektrische Signal durch steuernden Eingriff des Mikroprozessors auf eine Meßeinrichtung amplitudenmäßig ausgewertet wird.

Werden das Auswerteergebnis und ggf. die zugehörigen Einstellwerte abgespeichert, so ermöglicht dies vorteilhafterweise den automatisierten Sendefrequenzabgleich, bei dem die abgespeicherten Auswerteergebnisse und Einstellwerte mittels eines Programms im Mikroprozessor ausgewertet werden.

Weitere vorteilhafte Ausgestaltungen des erfindungsgemäßen Verfahrens sind den Ansprüchen 3 bis 5 zu entnehmen.

Hängt die Oszillatorfrequenz von der Amplitude einer am Oszillator angelegten Steuerspannung ab, die durch den Mikroprozessor verändert wird und daraufhin das elektrische Signal ändert, so ermöglicht dies auf einfache Weise eine Varianz der Sendefrequenz und damit den Sendefrequenzabgleich.

Vorteilhafterweise erfolgt die Veränderung der Steuerspannung durch Zustandswechsel an Ausgängen des Mikroprozessors, was nach Aktivierung des Abgleichsvorgangs, z.B. über eine Parametrierschnittstelle des Mikroprozessors, mit Hilfe eines im Mikroprozessor abgespeicherten Ablaufprogramms auf einfache Weise realisierbar ist. Die Zustandswechsel können darin bestehen, daß an die Ausgänge ein Spannungspotential +U, ein Massepotential oder ein hochohmiger Zustand vorgegeben wird.

Bewirken die Zustandswechsel an einem dem Oszillator vorgeschalteten Netzwerk-Potentialwechsel, so ist auf einfache Weise durch Veränderung der Potential-Pegelkombination mit Hilfe des Netzwerks die Steuerspannung am Oszillator veränderbar.

Vorteilhafterweise ist das elektrische Signal eine dem Verstärker zugeführte Regelspannung.

Die amplitudenmäßige Auswertung des Signals erfolgt durch Vergleich mit einer Referenzspannung, die durch Zustandswechsel an Ausgängen des Mikroprozessors verändert wird. Die Zustandswechsel bewirken an einem Widerstandsnetzwerk Potentialwechsel und ermöglichen eine Vielzahl von Pegelkombinationen mit entsprechenden Abstufungen der Referenzspannung.

Als besonders vorteilhaft hat es sich erwiesen, wenn der Mikroprozessor selbständig die Einstellwerte für die in Betrieb zu verwendende Sendefrequenz ermittelt, indem er aus den erfaßten Amplituden des elektrischen Signals die Höchste auswählt und abspeichert.

Die obengenannte zweite Aufgabe wird dadurch gelöst, daß eine vom Mikroprozessor steuerbare Meßeinrichtung vorgesehen ist, die zur Messung der Amplitude eines im Ultraschall-Näherungsschalter nach Empfang eines Ultraschall-Echosignals, weiterverarbeiteten elektrischen Signals dient, das proportional zur Amplitude des Ultraschall-Echosignals ist.

Eine vorteilhafte Weiterbildung der Erfindung besteht, wenn die Oszillatorfrequenz von der Amplitude einer am Eingang des Oszillators anliegenden Steuerspannung abhängt und der Eingang des Oszillators über ein Netzwerk mit Ausgängen des Mikroprozessors elektrisch verbunden ist, und wenn durch Zustandswechsel an den Ausgängen die Steuerspannung am Eingang veränderbar ist. Hierdurch ist die Sendefrequenz für den Sendefrequenzabgleich auf einfache Weise variierbar.

Eine besonders einfache Ausführung ist gegeben, wenn die Meßeinrichtung einen Komparator aufweist, der zum Vergleich der Amplituden des elektrischen Signals und einer amplitudenmäßig durch den Mikroprozessor veränderbaren Referenzspannung dient.

Eine weitere vorteilhafte Ausführung besteht, wenn zwischen einem Eingang des Komparators und Ausgängen des Mikroprozessors ein Netzwerk geschaltet ist und wenn durch Zustandswechsel an den Ausgängen die Referenzspannung veränderbar ist.

Die Erfindung wird im folgenden anhand einer Zeichnung näher erläutert.

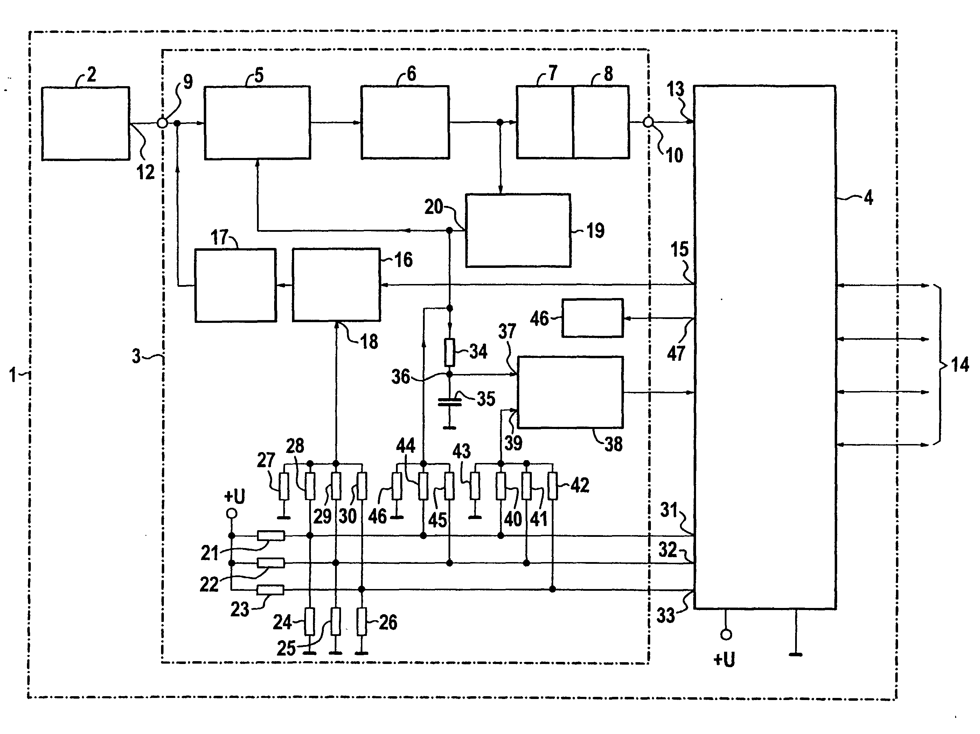

Die Figur zeigt den prinzipiellen schaltungsmäßigen Aufbau eines Ultraschall-Näherungsschalters 1, der im wesentlichen aus einem Ultraschall-Wandler 2, einer Weiterverarbeitungseinheit 3 und einem Mikroprozessor 4 aufgebaut ist. Die Weiterverarbeitungseinheit 3 weist hier einen aus einem Verstärker 5, einem Filter 6, einem Demodulator 7 und einem Komparator 8 aufgebauten Zweig auf, wobei die Komponenten in der genannten Reihenfolge in Serie geschaltet sind und am Eingang 9 der Weiterverarbeitungseinheit 3 der Verstärker 5 und am Ausgang 10 derselben der Komparator 8 liegt. Über eine Regelschleife mit einem Regelverstärker 19 erfolgt eine Rückkopplung zum Verstärker 5. Der Ausgang 12 des Ultraschall-Wandlers 2 ist über den Eingang 9 der Weiterverarbeitungseinheit 3 mit dem Verstärker 5 verbunden. Der Ausgang 10 der Weiterverarbeitungseinheit 3 liegt an einem Eingang 13 des Mikroprozessors 4, der eine Parametrierschnittstelle 14 aufweist. Zwischen einem Ausgang 15 des Mikroprozessors 4 und dem Eingang 9 ist eine Reihenschaltung aus einem Oszillator 16 und einer Sendeendstufe 17 geschaltet.

Im folgenden wird die Wirkungsweise des soweit bekannten Näherungsschalters erläutert.

Der Mikroprozessor 4 aktiviert über seinen Ausgang 15 den Oszillator 16, der abhängig von einer an seinem Eingang 18 anliegenden Steuerspannung ein Anregungssignal mit einer von der Amplitude der Steuerspannung abhängigen Oszillatorfrequenz erzeugt. Dieses Anregungssignal wird nach Verstärkung in der Sendeendstufe 17 an den Wandler 2 weitergeleitet, der ein Ultraschallsignal mit einer der Oszillatorfrequenz entsprechenden Sendefrequenz aussendet. Nach Reflexion der Ultraschallwellen an einem Objekt empfängt der Ultraschall-Wandler 2 ein Ultraschallecho und wandelt dieses in ein elektrisches Signal um. Dieses wird in der Weiterverarbeitungseinheit verstärkt, anschließend gefiltert, demoduliert und vor Übergabe an den Mikroprozessor 4 amplitudenmäßig erfaßt. Das elektrische Signal wird hier nach der Filterung außerdem über einen Regelverstärker 19 in der Weiterverarbeitungseinheit 3 verstärkt und die dann an seinem Ausgang 20 anliegende Regelspannung an den Verstärker 5 rückgeführt. Über die Parametrierschnittstelle 14 des Mikroprozessors 4 wird ermöglicht, Daten in den Mikroprozessor 4 ein- und auszulesen.

Mit dem Mikroprozessor ist eine Leuchtdiode 46 verbunden, die nach einer Initialisierung die Signalamplitude des Ultraschall-Echosignals durch Helligkeitsschwankungen darstellt bzw. durch Blinken zu geringe Signalreserven anzeigt.

Erfindungsgemäß ist der soweit beschriebene Ultraschall-Näherungsschalter 1 mit einem Widerstandsnetzwerk versehen, das Spannungsteilerwiderstände 21 bis 26 sowie zusätzliche Widerstände 27 bis 30 aufweist. Durch die Widerstandspaare 21, 24; 22, 25 und 23, 26 sind drei Spannungsteiler gebildet, deren Mittelpunkt jeweils an einen der Ausgänge 31, 32 bzw. 33 des Mikroprozessors 4 geschaltet ist und die einerseits an das gemeinsame Potential +U und andererseits an das Massepotential angeschlossen sind. Die Mittelpunkte der genannten Spannungsteiler sind jeweils über einen der Widerstände 28, 29 und 30 mit dem Eingang 18 des Oszillators 16 verbunden. An dem gemeinsamen verbindungspunkt der Widerstände 28, 29, 30 ist außerdem der Widerstand 27 zum Massepotential hin angeschlossen.

Am Ausgang 20 des Regelverstärkers 19 ist ein Tiefpaß aus einem ohmschen Widerstand 34 und einem Kondensator 35 vorgesehen. Deren Verbindungspunkt 36 ist an einem ersten Eingang 37 eines Komparators 38 angeschlossen, der ausgangsseitig mit dem Mikroprozessor 4 verbunden ist. Ein zweiter Eingang 39 des Komparators 38 ist über Widerstände 40, 41, 42 mit den Ausgängen 31, 32 bzw. 33 verbunden. Ein weiterer Widerstand 43 ist am Verbindungspunkt 39 zum Massepotential hin angeschlossen.

Weiterhin besteht eine Verbindung zwischen den Ausgängen 31 bzw. 32 des Mikroprozessors 4 einerseits und dem Ausgang 20 des Regelverstärkers 19 durch zwei weitere Widerstände 44 und 45, zu denen ein Widerstand 46 vom Verbindungspunkt zum Massepotential parallel geschaltet ist.

Im folgenden wird die Funktion des vorangehend beschriebenen Näherungsschalters 1 mit Betriebsoptimierung näher erläutert.

Die Betriebsoptimierung, hier der Sendefrequenzabgleich, des Näherungsschalters 1 wird über die Parametrierschnittstelle 14 aktiviert. Daraufhin werden die Ausgänge 31, 32, 33 des Mikroprozessors 4 in geeigneter Kombination nach High-Pegel (+U), Low-Pegel (Massepotential) oder Tristate (hochohmiger Zustand) geschaltet. Im Tristate-Betrieb liegt aufgrund der Spannungsteiler-Widerstände 21 bis 26 die Hälfte der gemeinsamen Versorgungsspannung +U an den Mittelpunkten der Spannungsteiler an, in den anderen beiden Zuständen entweder die volle Versorgungsspannung +U oder das Massepotential. Während der zyklische Sendetakt über den Ausgang 15 aktiv ist, wird die Oszillatorfrequenz des am Ausgang vom Oszillator 16 anstehenden Anregungssignals schrittweise über die Widerstände 27 bis 30 rampenförmig mit der maximal möglichen Auflösung von 27 Schritten angesteuert. Die Widerstände 28 bis 30 haben je nach Gewichtung entsprechend den Ausgängen 31, 32 und 33 eine wertemäßige Abstufung jeweils um den Faktor 3 und bilden zusammen mit dem Widerstand 27 einen Spannungsteiler zur Erzeugung der Steuerspannung mit unterschiedlicher Amplitude. Das Anregungssignal mit der entsprechenden Oszillatorfrequenz des Oszillators 16 wird während des über den Ausgang 15 vorgegebenen Sendetaktes freigegeben und gelangt über die Sendeendstufe 17 an den Ultraschall-Wandler 2.

Die Ultraschallwellen werden daraufhin vom Ultraschall-Wandler 2 mit der entsprechenden Sendefrequenz abgestrahlt und nach der Reflexion als Echo wieder empfangen. Im Verstärker 5 wird das vom Ultraschall-Wandler 2 erhaltene elektrische Signal auf einen verarbeitbaren Pegel gebracht, im nachgeschalteten Filter 6 von eventuellen Störsignalen befreit und nach Weiterverarbeitung im Demodulator 7 und Komparator 8 zur Auswertung im Mikroprozessor 4 eingespeist.

Um eine Übersteuerung des gefilterten elektrischen Signals und damit eine Reduzierung der Abgleichdynamik zu vermeiden, wird die Signalverstärkung über die Ansteuerung der Widerstände 44 bis 46 in Spannungsteilerschaltung durch die Ausgänge 31, 32 des Mikroprozessors 4 entsprechend angepaßt.

Die Information für den optimalen Abgleichwert für die Sendefrequenz wird durch Messung der den Echoamplituden proportionalen Regelspannung am Ausgang 20 des Regelverstärkers 19 bei der jeweils über den Oszillator 16 eingestellten Sendefrequenz erhalten. Hierzu wird mit Hilfe der Widerstände 40 bis 43 ein rampenförmiges Referenzsignal am Eingang 39 des Komparators 38 eingespeist und hier mit der Regelspannung verglichen. Diese wird durch den Tiefpaß, bestehend aus dem Widerstand 34 und dem Kondensator 35, gemittelt und steht damit für die Messung als zeitunkritisches Signal zur Verfügung. Ausgangsseitig wird am Komparator 38 ein digitalisiertes Signal ausgegeben, dessen Pulsweitenvarianz die gemessene Amplitude wiedergibt und im Mikroprozessor 4 weiterverarbeitet wird.

Bei externer Verarbeitung werden die Pegel der Regelspannung je nach Geräteausführung in Strom-, Spannungs- oder Frequenzwerte umgewandelt, in einem gesonderten Prüfaufbau zyklisch gemessen und dort den entsprechenden Sendefrequenzwerten zugeordnet. Es wird dann der optimale Abgleichwert bei Regelspannungsmaximum ermittelt und dieser Frequenzwert bzw. die entsprechenden Einstellwerte per Parametrierschnittstelle 14 dem Mikroprozessor 4 zur Abspeicherung übergeben.

Bei interner Verarbeitung ermittelt der Mikroprozessor 4 anhand eines hier nicht näher zu beschreibenden Ablaufprogramms die optimale Abgleichfrequenz für den Ultraschall-Wandler 2 und speichert die hierfür ermittelte Pegelkombination an den Ausgängen 31 bis 33 des Mikroprozessors 4 ab.

Nach Abschluß des Sendefrequenz-Abgleichvorgangs liegt dann im Normalbetrieb des Ultraschall-Näherungsschalters 1 die ermittelte Pegelkombination für die optimale Sendefrequenz des Ultraschall-Wandlers 2 während des Sendetaktes an den Ausgängen 31 bis 33 des Mikroprozessors 4 an.

Erhält der Mikroprozessor 4 Informationen über die Außentemperatur, so kann für den Normalbetrieb eine automatische Nachführung der Oszillatorfrequenz über die Ausgänge 31 bis 33 zur Anpassung an die Temperaturdrift der Resonanzfrequenz des Ultraschall-Wandlers 2 erfolgen. Hierzu ist allerdings Voraussetzung, daß im Mikroprozessor 4 der Einfluß der Temperatur auf die Frequenz des Ultraschall-Wandlers sowie die jeweils gültige Pegelkombination zur Nachführung der Oszillatorfrequenz abgespeichert sind.

Die Einstell- und Meßfunktionen am Mikroprozessor 4 werden durch die Ansteuerung des Widerstandsnetzwerks im Zeitmultiplexverfahren realisiert, was einen geringen Hardware-Aufwand ermöglicht. Durch eine Erweiterung des Widerstandsnetzwerks und der Mikroprozessorausgänge kann die Auflösung der Einstell- und Meßfunktionen nahezu beliebig gesteigert werden. In Verbindung mit der üblicherweise vorhandenen Parametrierschnittstelle 14 ist ein automatisierter Sendefrequenzabgleich des kompletten und eventuell bereits vergossenen Näherungsschalters 1 ohne zusätzliche Kontaktiermaßnahmen auch vor Ort in der Anwendung möglich.

Die geräteinterne Messung der Prüfsignale vermeidet die ansonsten bei externer Signalauskopplung üblichen Probleme durch Störeinflüsse infolge von Masseschleifen, Rauschsignalen, Schwingneigungen usw.

Ein weiterer Vorteil des oben beschriebenen Näherungsschalters ist es, daß die Ausgabe der Meßwerte und eventueller Fehler sowie die Einstellung der Abgleichparameter ohne zusätzlichen Hardware-Aufwand und mit wesentlich einfacheren Fertigungsvorrichtungen über die Parametrierschnittstelle des Näherungsschalters erfolgen kann.

Mit dem vorangehend beschriebenen Aufbau des Näherungsschalters 1 ist die optimale Ausrichtung des US-Wandlers 2 als weitere Betriebsoptimierung möglich.

Die Information für den optimalen Ausricht-Punkt wird durch die Messung der echoamplituden-proportionalen Regelspannung am Ausgang 20 des Regelverstärkers 19 erhalten. Diese Messung entspricht der Regelspannungsmessung wie sie für den optimalen Sendefrequenzabgleich vorangehend beschrieben wurde. Mit Hilfe der Widerstände 40 bis 43 wird ein rampenförmiges Referenzsignal am Eingang 39 des Komparators 38 eingespeist und hier mit der Regelspannung verglichen. Dieser wird durch den Tiefpaß, bestehend aus dem Widerstand 34 und dem Kondensator 35, gemittelt und steht damit für die Messung als zeitunkritisches Signal zur Verfügung. Ausgangsseitig wird am Komparator 38 ein digitalisiertes Signal ausgegeben, dessen pulsweiten Varianz die gemessene Amplitude widergibt und im Mikroprozessor 4 weiterverarbeitet wird. Durch Helligkeitsänderung oder Taktung einer eventuell bereits für andere Zwecke im Näherungsschalter 1 vorhandenen Leuchtdiode 46 durch einen Prozessorausgang 47 kann die aus dem digitalisierten Signal entsprechend aufbereitete Ausricht-Information am Näherungsschalter 1 angezeigt werden. Gleichzeitig kann die Ausricht-Information durch die standardmäßig vorhandene Parametrierschnittstelle 14 über ein spezielles externes Schnittstellen-Interface in Echtzeit zur Visualisierung, z.B. als Balkendiagramm auf einen Personalcomputer gegeben werden.

## Patentansprüche

1. Verfahren zur Betriebsoptimierung eines Ultraschall-Näherungsschalters (1), der einen Ultraschall-Wandler (2), einen Oszillator (16), einen Verstärker (5) und einen Mikroprozessor (4) umfaßt, wobei der Oszillator (16) den Ultraschallwandler (2) mit einer Oszillatorfrequenz anregt und der Ultraschall-Wandler (2) daraufhin ein Ultraschallsignal aussendet, das er nach Reflexion als Ultraschall-Echosignal empfängt und in ein elektrisches Signal umwandelt, das im Ultraschall-Näherungsschalter (1) weiterverarbeitet wird und proportional zur Amplitude des empfangenen Ultraschall-Echosignals ist, und das durch steuernden Eingriff des Mikroprozessors (4) auf eine Meßeinrichtung (38,40,41,42,43) amplitudenmäßig ausgewertet wird, **dadurch gekennzeichnet, daß** die Oszillatorfrequenz von der Amplitude einer am Oszillator (16) angelegten Steuerspannung abhängt, die durch den Mikroprozessor (4) verändert wird und daraufhin das elektrische Signal ändert und daß die Veränderung der Steuerspannung durch Zustandswechsel an den Ausgängen (31,32,33) des Mikroprozessors (4) erfolgt und daß die amplitudenmäßige Auswertung des elektrischen Signals durch Vergleich mit einer Referenzspannung erfolgt, die durch Zustandswechsel an den Ausgängen (31,32,33) des Mikroprozessors (4) veränderbar ist.

2. Verfahren nach Anspruch 2, **dadurch gekennzeichnet, daß** das Ergebnis der Amplitudenauswertung und ggf. zugehörige Einstellwerte abgespeichert werden.

3. Verfahren nach Anspruch 1 oder 2, **dadurch gekennzeichnet, da**ß die Zustandswechsel an einem dem Oszillator (16) vorgeschalteten Netzwerk mit Widerständen (21...30) Potentialwechsel bewirken.

4. Verfahren nach einem der vorangehenden Ansprüche, **dadurch gekennzeichnet, daß** der Mikroprozessor (4) selbständig die Einstellwerte für die im Betrieb zu verwendende Sendefrequenz ermittelt , indem er aus den erfaßten Amplituden des elektrischen Signals die höchste auswählt und abspeichert.

5. Verfahren nach einem der vorangehenden Ansprüche, **dadurch gekennzeichnet, daß** das elektrische Signal eine dem Verstärker (5) zugeführte Regelspannung ist.

6. Ultraschall-Näherungsschalter (1) mit einem Ultraschall-Wandler (2), mit einem Oszillator (16), durch den der Ultraschall-Wandler (2) zur Aussendung von Ultraschallwellen mit einer der Oszillatorfrequenz entsprechenden Sendefrequenz anregbar ist, mit einem Mikroprozessor (4) zur Steuerung und Auswertung der Sende- und Empfangssignale des Ultraschall-Näherungsschalters (1) und mit einer vom Mikroprozessor (4) steuerbaren Meßeinrichtung (38,40,41,42,43), die zur Messung der Amplitude eines im Ultraschall-Näherungsschalters (1) nach Empfang des Ultraschall-Echosignals, weiterverarbeiteten elektrischen Signals dient, das proportional zur Amplitude des Ultraschall-Echosignals ist, **dadurch gekennzeichnet, daß** die Oszillatorfrequenz von der Amplitude einer am Eingang (18) des Oszillators (16) anliegenden Steuerspannung abhängt, das der Eingang (18) des Oszillators (16) über ein Netzwerk (21,22,23,24,25,26,27,28,29,30) mit den Ausgängen (31,32,33) des Mikroprozessors (4) elektrisch verbunden ist, und daß durch Zustandswechsel an den Ausgängen (31,32,33) die Steuerspannung am Eingang (18) veränderbar ist, und daß durch Zustandswechsel an den Ausgängen (31,32, 33) die Referenzspannung veränderbar ist.

7. Ultraschall-Näherungsschalter nach Anspruch 6, **dadurch gekennzeichnet, daß** die Meßeinrichtung einen Komparator (38) aufweist, der zum Vergleich der Amplituden des elektrischen Signals und einer amplitudenmäßig durch den Mikroprozessor (4) veränderbaren Referenzspannung dient.

## Claims

1. Method for optimising the operation of an ultrasonic proximity switch (1), which incorporates an ultrasonic transducer (2), an oscillator (16), an amplifier (5) and a microprocessor (4), in which the oscillator (16) excites the ultrasonic transducer (2) with an oscillator frequency causing the ultrasonic transducer (2) to emit an ultrasonic signal, which it then receives after reflection as an ultrasonic echo signal and converts to an electrical signal, which is then post-processed in the ultrasonic proximity switch (1) and which is proportional to the amplitude of the ultrasonic echo which has been received, and which by the controlling intervention of the microprocessor (4) is analysed on a measurement device (38,40,41,42,43) in terms of its amplitude, **characterised in that** the oscillator frequency depends on the amplitude of a control voltage applied to the oscillator (16), this voltage being changed by the microprocessor (4) thereby causing the electrical signal to change, the change in the control voltage being effected by state changes at the outputs (31,32,33) of the microprocessor (4), and that an analysis of the electrical signal in terms of its amplitude is effected by a comparison with a reference voltage, which can be changed by state changes at the outputs (31,32,33) of the microprocessor (4).

2. Method in accordance with claim 2, **characterised in that** the result of the amplitude analysis and any appropriate adjustment values are stored away.

3. Method in accordance with claim 1 or 2, **characterised in that** the state changes cause a change in the potential in a network with resistances (21...30) connected upstream from the oscillator (16).

4. Method in accordance with one of the preceding claims, **characterised in that** the microprocessor (4) determines autonomously the adjustment values for the transmission frequency which is to be used in operation, by selecting and storing away the highest of the recorded amplitudes for the electrical signal.

5. Method in accordance with one of the preceding claims, **characterised in that** the electrical signal is a regulating voltage which is fed to the amplifier (5).

6. Ultrasonic proximity switch (1) with an ultrasonic transducer (2), with an oscillator (16) by which the ultrasonic transducer (2) can be excited to emit ultrasonic waves with a transmission frequency corresponding to the oscillator frequency, with a microprocessor (4) for controlling and analysing the transmitted and received signals of the ultrasonic proximity switch (1) and with a measurement device (38,40,41,42,43) which can be controlled by the microprocessor (4), which device is used to measure the amplitude of an electrical signal, which has been post-processed in the ultrasonic proximity switch (1) after the ultrasonic echo signal is received, which electrical signal is proportional to the amplitude of the ultrasonic echo signal, **characterised in that** the oscillator frequency depends on the amplitude of a control voltage applied to the input (18) of the oscillator (16), that the input (18) of the oscillator (16) is connected electrically via a network (21,22,23,24,25,26,27,28,29,30) to the outputs (31,32,33) of the microprocessor (4), and that the control voltage at the input (18) can be changed by state changes at the outputs (31,32,33), and that the reference voltage can be changed by state changes at the outputs (31,32,33).

7. Ultrasonic proximity switch in accordance with claim 6, **characterised in that** the measurement device has a comparator (38), which is used for comparing the amplitude of the electrical signal with a reference voltage, the amplitude of which can be changed by the microprocessor (4).

## Revendications

1. Procédé d'optimisation du fonctionnement d'un interrupteur (1) de proximité à ultrasons qui comprend un émetteur (2) d'ultrasons, un oscillateur (16), un amplificateur (5) et un microprocesseur (4), l'oscillateur (16) excitant l'émetteur (2) d'ultrasons à une fréquence d'oscillateur et l'émetteur (2) d'ultrasons émettant alors un signal d'ultrasons qu'il reçoit après réflexion sous la forme d'un signal d'écho d'ultrasons et qu'il transforme en un signal électrique qui est re-traité dans l'interrupteur (1) de proximité à ultrasons et qui est proportionnel à l'amplitude du signal d'écho d'ultrasons reçu et qui est évalué en amplitude sur un dispositif (38, 40, 41, 42, 43) de mesure par attaque commandée du microprocesseur (4), **caractérisé en ce que** la fréquence d'oscillateur dépend de l'amplitude d'une tension de commande appliquée à l'oscillateur (16), qui est modifiée par le microprocesseur (4) et qui modifie alors le signal électrique, et **en ce que** la modification de la tension de commande s'effectue par changement d'état sur les sorties (31, 32, 33) du microprocesseur (4), et **en ce que** l'évaluation en amplitude du signal électrique s'effectue par comparaison à une tension de référence, qui peut être modifiée par changement d'état sur les sorties (31, 32, 33) du microprocesseur (4).

2. Procédé suivant la revendication 1, **caractérisé en ce que** le résultat de l'évaluation en amplitude et, le cas échéant, des valeurs de réglage associées sont mémorisés.

3. Procédé suivant la revendication 1 ou 2, **caractérisé en ce que** le changement d'état provoque un changement de potentiel sur un réseau en amont de l'oscillateur (16) ayant des résistances (21 ... 30).

4. Procédé suivant l'une des revendications précédentes, **caractérisé en ce que** le microprocesseur (4) détermine automatiquement les valeurs de réglage pour la fréquence d'émission à utiliser en fonctionnement, en choisissant parmi les amplitudes détectées du signal électrique la plus grande et en la mémorisant.

5. Procédé suivant l'une des revendications précédentes, **caractérisé en ce que** le signal électrique est une tension de régulation envoyée à l'amplificateur.

6. interrupteur (1) de proximité à ultrasons ayant un émetteur (2) d'ultrasons, un oscillateur (16) par lequel l'émetteur (2) d'ultrasons peut être excité pour émettre des ondes ultrasonores ayant une fréquence d'émission correspondant à la fréquence de l'oscillateur, un microprocesseur (4) de commande et d'évaluation des signaux d'émission et de réception de l'interrupteur (1) de proximité à ultrasons et un dispositif (38, 40, 41, 42, 43) de mesure pouvant être commandé par le microprocesseur (4) et servant à mesurer l'amplitude d'un signal électrique re-traité dans l'interrupteur (1) de proximité à ultrasons après réception du signal d'écho d'ultrasons, ce signal étant proportionnel à l'amplitude du signal d'écho d'ultrasons, **caractérisé en ce que** la fréquence de l'oscillateur dépend de l'amplitude d'une tension de commande appliquée à l'entrée (18) de l'oscillateur (16), **en ce que** l'entrée (18) de l'oscillateur (16) est reliée électriquement par un réseau (21, 22, 23, 24, 25, 26, 27, 28, 29, 30) aux sorties (31, 32, 33) du microprocesseur (4), et **en ce que** la tension de commande à l'entrée (18) peut être modifiée par changement d'état sur les sorties (31, 32, 33), et **en ce que** la tension de référence peut être modifiée par changement d'état sur les sorties (31, 32, 33).

7. Interrupteur de proximité à ultrasons suivant la revendication 6, **caractérisé en ce que** le dispositif de mesure comporte un comparateur (38) qui sert pour comparer l'amplitude du signal électrique et une tension de référence qui peut être modifiée en amplitude par le microprocesseur (4).
